# FASCICULE DE BREVET EUROPEEN

(11) **EP 0 834 990 B1**
(45) Date de publication et mention de la délivrance du brevet: **27.03.2002**
(21) Numéro de dépôt: 97202963.1
(22) Date de dépôt: 26.09.1997
(51) Int. Cl.: H03H 11/20

(54) **Déphaseur numérique programmable et convertisseur analogique/numérique mettant en oeuvre un tel déphaseur**
Programmierbarer digitaler Phasenschieber und Analog-Digital-Umsetzer damit
Digital programmable phase shifter and analog-digital converter using such a phase shifter

(30) Priorité: 02.10.1996 FR 9612015
(43) Date de publication de la demande: 08.04.1998
(73) Titulaire: Koninklijke Philips Electronics N.V., 5621 BA Eindhoven (NL)
(72) Inventeur: Marie, Hervé, 75008 Paris (FR)
(74) Mandataire: Chaffraix, Jean

(56) Documents cités:
- DE-A- 4 420 376
- CIARDULLO D J: "A HIGH ACCURACY OHASE SHIFTER BASED ON A VECTOR MODULATOR" RF DESIGN, vol. 16, no. 11, 1 octobre 1993, pages 106-112, 114, XP000404289
- FAZAL ALI ET AL: "A SINGLE CHIP C - BAND GAAS MONOLITHIC FIVE BIT PHASE SHIFTER WITH ON CHIP DIGITAL DECODER" MTT-S INTERNATIONAL MICROWAVE SYMPOSIUM DIGEST, DALLAS, MAY 8 - 10, 1990, vol. 3, 8 mai 1990, INSTITUTE OF ELECTRICAL AND ELECTRONICS ENGINEERS, pages 1235-1237, XP000144163

## Description

La présente invention concerne un déphaseur programmable, présentant une première entrée destinée à recevoir un signal d'entrée à déphaser, une deuxième entrée destinée à recevoir un signal numérique dit de commande, et une sortie destinée à délivrer un signal de sortie présentant par rapport au signal d'entrée un déphasage dont une valeur X est définie par le signal de commande, déphaseur programmable comprenant :
. un module dit quadratique présentant une entrée reliée à la première entrée du déphaseur programmable et une sortie destinée à délivrer un signal en quadrature de phase avec le signal d'entrée,
. un premier et un deuxième multiplieurs présentant chacun une première et une deuxième entrées et une sortie, la première entrée du premier multiplieur étant reliée à la première entrée du déphaseur programmable, la première entrée du deuxième multiplieur étant reliée à la sortie du module quadratique, la sortie du premier multiplieur étant destinée à délivrer un signal résultant de la multiplication du signal reçu sur sa première entrée par une valeur sensiblement égale à V.cos(X), où V représente une tension continue, la sortie du deuxième multiplieur étant destinée à délivrer un signal résultant de la multiplication du signal reçu sur sa première entrée par une valeur sensiblement égale à V.sin(X), les valeurs de V.cos(X) et de V.sin(X) étant définies par des signaux élaborés sur la base du signal de commande et reçus par les multiplieurs sur leur deuxième entrée,
. un additionneur présentant une première entrée reliée à la sortie du premier multiplieur, une deuxième entrée reliée à la sortie du deuxième multiplieur, et destiné à délivrer, sur une sortie reliée à la sortie du déphaseur programmable, un signal résultant de la somme des signaux reçus sur ses première et deuxième entrées.

Un tel déphaseur programmable est connu du brevet anglais n° 1 527 603. Le déphaseur qui y est décrit comporte un potentiomètre générant, sur la base d'un signal de commande analogique, une première tension analogique dont la valeur est sensiblement égale à V.sin(X) et une deuxième tension analogique dont la valeur est sensiblement égale à V.cos(X). Le signal d'entrée, qui est par exemple de la forme A.cosωt, est multiplié au sein du premier multiplieur par le signal que celui-ci reçoit sur sa deuxième entrée, soit V.cos(X), tandis qu'un signal en quadrature de phase avec le signal d'entrée et s'exprimant donc sous la forme A.sinωt, est multiplié au sein du deuxième multiplieur par le signal que celui-ci reçoit sur sa deuxième entrée, soit V.sin(X). Le signal de sortie de l'additionneur est donc de la forme A'.(cosωt.cos(X)+sinωt.sin(X)), ce qui correspond à A'.cos(ωt-X). La valeur de X, implicitement définie par le signal de commande, détermine donc le déphasage que présente le signal de sortie par rapport au signal d'entrée.

Le document "a high accuracy phase shifter based on a vector modulator", RF Design, vol. 16, no. 11, 1 october 1993, pages 106-112,114, divulgue un déphaseur programmable dans lequel le signal de commande est un signal analogique ou numérique. Ce déphaseur programmable comprend deux générateurs de fonctions trigonométriques qui sont commandés par un convertisseur numérique - analogique dans le cas d'un signal de commande numérique, et deux multiplieurs analogiques. Ainsi, un signal numérique de commande est tout d'abord converti en signal analogique avant d'être appliqué à l'entrée des deux générateurs de fonctions trigonométriques. Les deux générateurs génèrent respectivement un premier signal analogique qui est proportionnel à cos(X) et un second signal analogique qui est proportionnel à sin(X). Chacun des signaux analogiques ainsi générés est ensuite fourni à une entrée de chaque multiplieur analogique.

Du fait de la nature analogique du potentiomètre ou du générateur de fonctions trigonométriques, les valeurs des tensions qu'il génère sur la base du signal de commande risquent de manquer de précision. L'erreur produite sur ces tensions, en elle-même difficilement maîtrisable, se trouve multipliée au sein des multiplieurs, lesquels engendrent de plus une erreur supplémentaire du fait de leur nature analogique. Ces erreurs accumulées risquent alors d'introduire un écart significatif entre le déphasage souhaité et celui effectivement obtenu au moyen du déphaseur programmable.

L'invention a pour but de remédier dans une large mesure à cet inconvénient, en proposant un déphaseur programmable dans lequel les opérations qui sont les plus susceptibles d'introduire des erreurs sont effectuées sous forme numérique.

En effet, un déphaseur programmable selon l'invention est caractérisé en ce que, le signal de commande est constitué d'un premier mot de commande définissant une valeur sensiblement égale à V.cos(X), et d'un deuxième mot de commande définissant une valeur sensiblement égale à V.sin(X), en ce que les multiplieurs sont des multiplieurs numériques, en ce que la deuxième entrée de chaque multiplieur est destinée à recevoir l'un des mots de commande, et en ce que chaque multiplieur est muni de moyens pour effectuer une multiplication du signal reçu sur sa première entrée par le signal reçu sur sa deuxième entrée.

Dans un tel déphaseur programmable, les contenus des mots de commande prennent des valeurs numériques discrètes, et introduisent inévitablement des erreurs d'approximation, mais ces erreurs sont parfaitement connues et maîtrisées. Elles peuvent être minimisées par un choix approprié des formats des mots de commande, qui permettront une définition d'autant meilleure, et donc des erreurs d'approximation d'autant plus faibles, que leur format sera grand.

Un mode de réalisation de l'invention se caractérise en ce que les multiplieurs sont des multiplieurs numériques. De tels multiplieurs n'introduisent pas d'erreurs supplémentaires, contrairement aux multiplieurs analogiques.

Différents modes de réalisation des multiplieurs sont possibles, en fonction du code utilisé pour définir les valeurs de V.cos(X) et de V.sin(X) au sein des mots de commande, et de la précision recherchée.

Un mode de réalisation particulier de l'invention présente un déphaseur programmable tel que décrit ci-dessus, caractérisé en ce que, le format des mots de commande étant de N bits, chaque multiplieur comporte :
. un étage dit de commutation composé de N-1 interrupteurs, chacun présentant une première et une deuxième bornes et une entrée, dite de commande, permettant de commander sa commutation, la première borne de chaque interrupteur étant reliée à la première entrée du multiplieur, les N-1 entrées de commande recevant N-1 bits provenant de la deuxième entrée du multiplieur,
. un additionneur présentant une sortie et N-1 entrées, chacune reliée à la deuxième borne d'un des N-1 interrupteurs de l'étage de commutation, et
. un module dit d'inversion présentant une première entrée reliée à la sortie de l'additionneur, une entrée de commande recevant celui des bits de la deuxième entrée du multiplieur qui ne commande aucun des interrupteurs de l'étage de commutation, appelé bit de signe, et une sortie constituant la sortie du multiplieur, module d'inversion destiné à opérer l'inversion du signe d'un signal reçu sur sa première entrée si le bit de signe est à un état actif, et à fonctionner comme un suiveur sinon.

Dans un tel déphaseur programmable, la valeur numérique du contenu de chacun des mots de commande correspond au nombre total de bits, à l'exception du bit de signe, qui sont à un niveau actif et permettent ainsi la mise en conduction des interrupteurs. Ce codage est avantageux car les valeurs des mots de commande sont complémentaires entre elles, à l'exception des bits de signe. L'élaboration du signal de commande s'en trouvera donc simplifiée.

Un mode de réalisation préféré de l'invention permet de réduire la taille des mots de commande, et donc la taille des additionneurs compris dans les multiplieurs, sans pour autant nuire à la précision du déphaseur.

Un déphaseur programmable conforme à ce mode de réalisation est caractérisé en ce qu'un étage d'amplification composé de N-1 amplificateurs est inséré au sein de chaque multiplieur, chaque amplificateur présentant une entrée reliée à la première entrée du multiplieur et une sortie, dont l'activation et la désactivation sont contrôlées au moyen de l'un des N-1 interrupteurs de l'étage de commutation, reliée à l'une des entrées de l'additionneur, le gain Gi du i^{ème} amplificateur (pour i=1 à N-1) étant égal à K fois le poids, au sein du mot de commande dont il provient, du bit commandant l'interrupteur qui contrôle l'activation et la désactivation de la sortie dudit i^{ème} amplificateur.

Un tel système de codage permet, par l'attribution d'un poids spécifique à chacun des bits constituant les mots de commande, d'élargir la gamme de valeurs générée par les combinaisons desdits bits. L'exemple du code binaire, dans lequel N bits peuvent décrire 2^{N} valeurs entières, illustre bien cet avantage.

Un déphaseur programmable selon l'invention peut être mis en oeuvre dans toute application nécessitant un contrôle temporel d'un signal. Dans des applications de conversion analogique/numérique de signaux video à haute fréquence, par exemple, un échantillonnage du signal doit avoir lieu pendant un laps de temps où ledit signal présente un palier de référence. A haute fréquence, ce laps de temps est très bref et un contrôle temporel du signal déterminant l'instant où doit se produire l'échantillonnage du palier de référence permet d'assurer que ledit échantillonnage s'effectue dans les conditions requises.

L'invention concerne donc également un convertisseur analogique/numérique, destiné à recevoir une tension d'entrée analogique à convertir en un signal de sortie numérique, comprenant :
. une échelle de résistances placées en série entre deux bornes d'alimentation, résistances destinées à fournir à leurs noeuds intermédiaires une pluralité de tensions dites de référence,
. un étage de comparateurs à deux entrées et une sortie, chacun destiné à recevoir sur une entrée la tension d'entrée analogique et sur l'autre entrée l'une des tensions de référence,
. un étage de mémorisation composé de bascules mémoire, chacune reliée à la sortie d'un des comparateurs afin de mémoriser le résultat d'une comparaison, et destinée à recevoir sur une entrée d'horloge un signal dit d'échantillonnage,
. un encodeur binaire connecté à l'étage de mémorisation pour en recevoir les informations mémorisées et fournissant le signal de sortie numérique du convertisseur,
caractérisé en ce que le convertisseur comporte en outre un déphaseur programmable tel que décrit plus haut, destiné à recevoir sur sa première entrée un signal d'horloge dont la fréquence est fixe, sur sa deuxième entrée un signal de commande numérique, et à fournir en sortie le signal d'échantillonnage, lequel présente par rapport au signal d'horloge un déphasage dont la valeur est définie par le signal de commande.

L'invention sera mieux comprise à l'aide de la description suivante de. quelques modes de réalisation, faite à titre d'exemple non-limitatif et en regard des dessins annexés, dans lesquels :
- la figure 1 est un schéma fonctionnel décrivant partiellement un déphaseur programmable selon l'invention,
- la figure 2 est un diagramme de Fresnel décrivant une gamme de déphasages obtenus au moyen de différentes valeurs numériques des mots de commande,
- la figure 3 est un schéma fonctionnel décrivant partiellement un multiplieur présent dans un déphaseur programmable selon un mode de réalisation de l'invention,
- la figure 4 est un schéma fonctionnel décrivant partiellement un multiplieur présent dans un déphaseur programmable selon un mode de réalisation préféré de l'invention, et
- la figure 5 est un schéma fonctionnel partiel d'un convertisseur analogique/numérique mettant en oeuvre un déphaseur programmable conforme à l'invention.

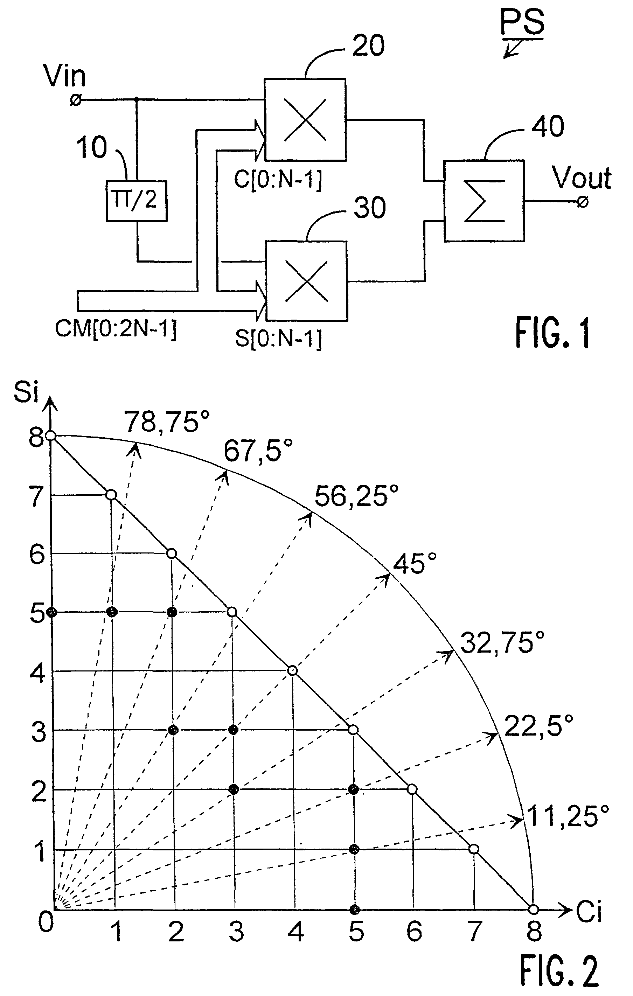

La figure 1 représente schématiquement un déphaseur programmable PS conforme à l'invention. Un tel déphaseur programmable présente une première entrée destinée à recevoir un signal d'entrée à déphaser Vin, par exemple de la forme A.cosωt, une deuxième entrée destinée à recevoir un signal numérique dit de commande CM[0:2N-1], et une sortie destinée à délivrer un signal de sortie Vout, de la forme A'.cos(ωt-X) dans ce cas de figure, et présentant ainsi par rapport au signal d'entrée un déphasage dont une valeur X est définie par le signal de commande CM[0:2N-1]. Ce déphaseur programmable PS comprend :
. un module 10, dit quadratique, présentant une entrée reliée à la première entrée du déphaseur programmable PS et une sortie destinée à délivrer un signal en quadrature de phase avec le signal d'entrée Vin, c'est-à-dire, dans ce cas de figure, de la forme A.sinωt,
. un premier et un deuxième multiplieurs 20 et 30 présentant chacun une première et une deuxième entrées et une sortie, la première entrée du premier multiplieur 20 étant reliée à la première entrée du déphaseur programmable PS, la première entrée du deuxième multiplieur 30 étant reliée à la sortie du module quadratique 10, la sortie du premier multiplieur 20 étant destinée à délivrer un signal résultant de la multiplication du signal Vin, de la forme A.cosωt. reçu sur sa première entrée par une valeur sensiblement égale à V.cos(X), où V représente une tension continue, la sortie du deuxième multiplieur 30 étant destinée à délivrer un signal résultant de la multiplication du signal, de la forme A.sinωt, reçu sur sa première entrée par une valeur sensiblement égale à V.sin(X), les valeurs de V.cos(X) et de V.sin(X) étant définies par des signaux élaborés sur la base du signal de commande CM[0:2N-1] et reçus par les multiplieurs 20 et 30 sur leur deuxième entrée,
. un additionneur 40 présentant une première entrée reliée à la sortie du premier multiplieur 20, une deuxième entrée reliée à la sortie du deuxième multiplieur 30, et destiné à délivrer, sur une sortie reliée à la sortie du déphaseur programmable PS, un signal Vout de la forme A'.cos(ωt-X)résultant de la somme des signaux reçus sur ses première et deuxième entrées.

Le signal de commande CM[0:2N-1] est constitué d'un premier mot de commande C[0:N-1] définissant une valeur sensiblement égale à V.cos(X), et d'un deuxième mot de commande S[0:N-1] définissant une valeur sensiblement égale à V.sin(X). La deuxième entrée de chacun des multiplieurs 20 et 30 est de nature numérique, et chaque multiplieur 20 et 30 est muni de moyens pour effectuer une multiplication numérique du signal reçu sur sa première entrée par le signal reçu sur sa deuxième entrée, la deuxième entrée de chacun des multiplieurs étant destinée à recevoir l'un des mots de commande C[0:N-1] ou S[0:N-1].

La figure 2 présente un diagramme de Fresnel sur la base duquel on peut déduire les valeurs numériques Si et Ci des mots de commande S[0:N-1] et C[0:N-1], en fonction du déphasage X souhaité, et du codage du contenu des mots de commande. Le déphasage X obtenu en sortie du déphaseur programmable y est exprimé en degrés. On a choisi de faire évoluer X par pas de 11,25°, ce qui permet d'obtenir au total 32 valeurs différentes de X. Seuls ont été représentés les cas où le déphasage X est compris entre 0 et 90°, les cas où X est compris entre 90° et 360° pouvant être aisément extrapolés de cette figure du fait de la parité de la fonction cosinus et de l'imparité de la fonction sinus. Les cercles blancs représentent des couples de valeurs (Ci, Si) dans le cas où celles-ci évoluent de 0 à 8. Les cercles noirs représentent des couples de valeurs entières (Ci, Si) dans le cas où celles-ci évoluent de 0 à 5. Dans le premier cas, le couple (Ci, Si) le mieux adapté pour obtenir un déphasage d'une valeur X proche de 22,5°, par exemple, est (6,2). Dans le deuxième cas, le couple le mieux adapté pour obtenir un déphasage du même ordre est (5,2). Les erreurs introduites dans ces approximations sont faibles et peu sujettes à variation, puisque étant le résultat d'une approximation numérique. Elles sont sensiblement équivalentes d'un cas de figure à l'autre.

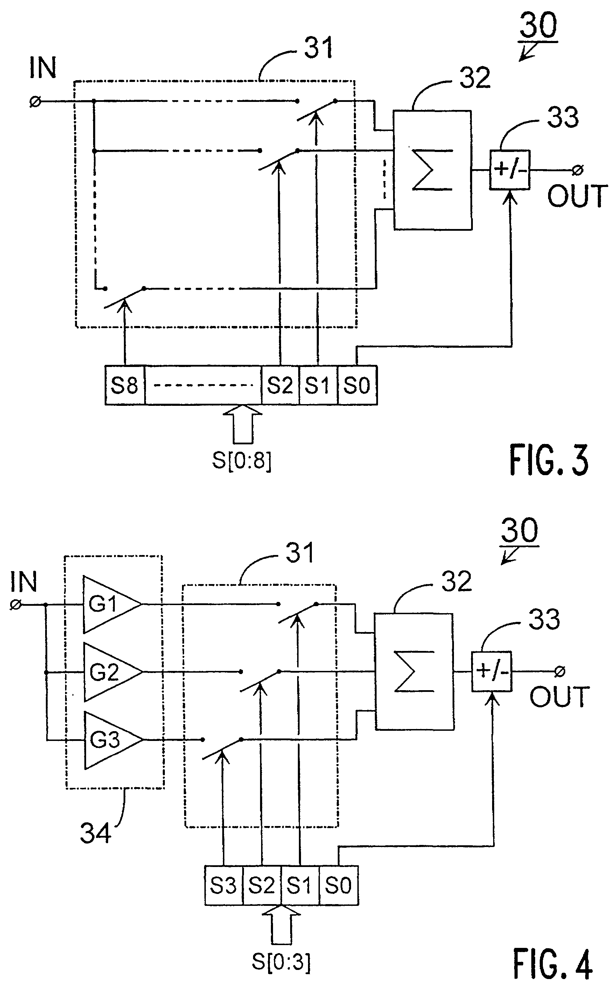

La figure 3 représente schématiquement un multiplieur 30 présent dans un déphaseur programmable PS selon un mode de réalisation de l'invention, dans le cas où le format de chaque mot de commande est de 9 bits (N=9). Un tel multiplieur comporte :
. un étage dit de commutation 31 composé de 8 interrupteurs, chacun présentant une première et une deuxième bornes et une entrée, dite de commande, permettant de commander sa commutation, la première borne de chaque interrupteur étant reliée à la première entrée IN du multiplieur 30, les 8 entrées de commande recevant 8 bits S1,S2,...S8 provenant de la deuxième entrée du multiplieur 30,
. un additionneur 32 présentant une sortie et 8 entrées, chacune reliée à la deuxième borne d'un des 8 interrupteurs de l'étage de commutation 31, et
. un module dit d'inversion 33 présentant une première entrée reliée à la sortie de l'additionneur 32, une entrée de commande recevant le bit SO de la deuxième entrée du multiplieur, lequel bit S0, appelé bit de signe, ne commande aucun des interrupteurs de l'étage de commutation 31, et une sortie constituant la sortie OUT du multiplieur 30, module d'inversion 33 destiné à opérer l'inversion du signe d'un signal reçu sur sa première entrée si le bit de signe SO est à un état actif, et à fonctionner comme un suiveur sinon.

La structure du multiplieur 20 est identique à celle du multiplieur 30. La valeur numérique du contenu de chacun des mots de commande correspond au nombre total de bits parmi S1,S2,...S8, qui sont à un niveau actif et permettent ainsi la mise en conduction des interrupteurs. Ainsi, si l'on souhaite obtenir un déphasage X de 22,5°, la figure 2 donne (Ci,Si)=(6,2). En considérant que le bit de signe est au niveau inactif quand il vaut 0, cette condition est validée en choisissant par exemple une valeur 000000110 pour Ci et une valeur 111111000 pour Si. Ce codage est avantageux car les valeurs des mots de commande sont complémentaires entre elles, à l'exception des bits de signe. L'élaboration du signal de commande s'en trouvera donc simplifiée.

La figure 4 représente schématiquement un multiplieur 30 présent dans un déphaseur programmable PS selon un mode de réalisation préféré de l'invention, dans le cas où le format de chaque mot de commande est réduit à 4 bits (N=4), sans pour autant nuire à la précision du déphasage obtenu. Le multiplieur 30 représenté sur la figure 4 comprend un étage de commutation 31 composé de trois interrupteurs commandés par trois bits S1,S2,S3, provenant de la deuxième entrée du multiplieur 30, laquelle reçoit un signal S[0:3]. Le multiplieur 30 comprend en outre un additionneur 32 présentant une sortie et 3 entrées et un module d'inversion 33, commandé par le bit de signe S0, dont la première entrée est reliée à la sortie de l'additionneur 32 et dont la sortie constitue la sortie OUT du multiplieur 30. Un étage d'amplification 34 composé de 3 amplificateurs est inséré au sein du multiplieur 30, chaque amplificateur présentant une entrée reliée à la première entrée IN du multiplieur 30 et une sortie, dont l'activation et la désactivation sont contrôlées au moyen de l'un des 3 interrupteurs de l'étage de commutation 31, reliée à l'une des 3 entrées de l'additionneur 32. Le gain Gi du i^{ème} amplificateur (pour i=1 à 3) est égal à K fois le poids, au sein du mot de commande dont il provient, du bit commandant l'interrupteur qui contrôle l'activation et la désactivation de la sortie dudit i^{ème} amplificateur.

La structure du multiplieur 20 est identique à celle du multiplieur 30. La figure 2 montre que, pour obtenir un déphasage X de 22,5°, et dans l'hypothèse où les valeurs de Ci et Si sont inférieures ou égales à 5, le couple (Ci,Si)=(5,2) convient. En attribuant par exemple aux bits C1 et S1 des mots de commande C[0:N-1] et S[0:N-1] le poids 1, aux bits C2 et S2 le poids 2, et aux bits C3 et S3 également le poids 2, ce qui est réalisé en construisant les amplificateurs de l'étage d'amplification de sorte que G1=K, G2=2.K et G3=2.K, la condition (Ci,Si)=(5,2) est réalisée en choisissant par exemple une valeur 1110 pour Ci et une valeur 0100 pour Si. La structure d'ensemble du déphaseur programmable est donc simplifiée, du fait de la réduction de la complexité des multiplieurs, d'une part, et de la réduction du format du signal de commande, d'autre part.

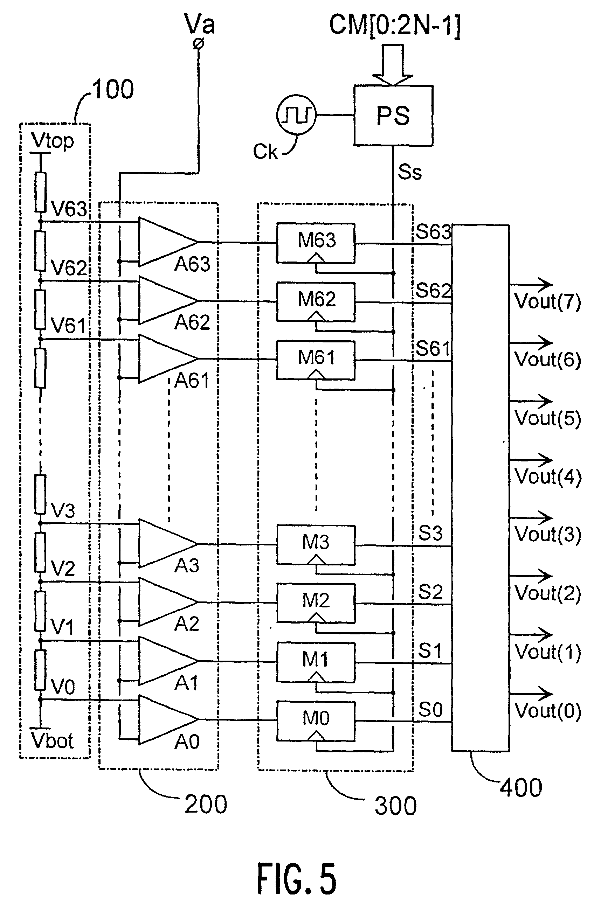

La figure 5 représente partiellement un convertisseur analogique/numérique qui met en oeuvre un déphaseur programmable PS conforme à l'invention. Ce convertisseur analogique/numérique, destiné à recevoir une tension d'entrée analogique Va à convertir en un signal de sortie numérique, codé sur 8 bits dans cet exemple, Vout[0:7], comprend :
. une échelle 100 de résistances placées en série entre deux bornes d'alimentation, Vbot et Vtop, résistances destinées à fournir à leurs noeuds intermédiaires une pluralité de tensions V0,V1,...V63, dites de référence,
. un étage 200 de comparateurs A0,A1,...A63 à deux entrées et une sortie, chacun destiné à recevoir sur une entrée la tension d'entrée analogique Va et sur l'autre entrée l'une des tensions de référence V0,V1,...V63,
. un étage 300 de mémorisation composé de bascules mémoire, M0,M1,...M63, chacune reliée à la sortie d'un des comparateurs A0,A1,...A63 afin de mémoriser le résultat d'une comparaison, et recevant sur une entrée d'horloge un signal Ss dit d'échantillonnage, et
. un encodeur binaire 400 connecté à l'étage de mémorisation 300 pour en recevoir les informations mémorisées et fournissant le signal de sortie numérique Vout[0:7] du convertisseur,

Le convertisseur comporte en outre un déphaseur programmable PS tel que décrit plus haut, recevant sur sa première entrée un signal d'horloge Ck dont la fréquence est fixe, sur sa deuxième entrée un signal de commande numérique CM[0:2N-1], et fournissant en sortie le signal d'échantillonnage Ss, lequel présente par rapport au signal d'horloge Ck un déphasage X dont la valeur est définie par le signal de commande CM[0:2N-1].

Lorsque ce convertisseur est utilisé dans des applications de conversion analogique/numérique de signaux video à haute fréquence, le déphaseur programmable permet, par un choix approprié de la valeur de X, de caler le front actif du signal d'échantillonnage Ss sur un palier de référence du signal d'entrée Va, de sorte que l'échantillonnage dudit palier de référence s'effectue dans des conditions optimales.

## Revendications

1. Déphaseur programmable (PS), présentant une première entrée destinée à recevoir un signal d'entrée (Vin) à déphaser, une deuxième entrée destinée à recevoir un signal numérique dit de commande (CM[0:2N-1]), et une sortie destinée à délivrer un signal de sortie (Vout) présentant par rapport au signal d'entrée un déphasage dont une valeur X est définie par le signal de commande, déphaseur programmable comprenant :
. un module dit quadratique (10) présentant une entrée reliée à la première entrée du déphaseur programmable et une sortie destinée à délivrer un signal en quadrature de phase avec le signal d'entrée,
. un premier (20) et un deuxième (30) multiplieurs présentant chacun une première et une deuxième entrées et une sortie, la première entrée du premier multiplieur étant reliée à la première entrée du déphaseur programmable, la première entrée du deuxième multiplieur étant reliée à la sortie du module quadratique, la sortie du premier multiplieur étant destinée à délivrer un signal résultant de la multiplication du signal reçu sur sa première entrée par une valeur sensiblement égale à V.cos(X), où V représente une tension continue, la sortie du deuxième multiplieur étant destinée à délivrer un signal résultant de la multiplication du signal reçu sur sa première entrée par une valeur sensiblement égale à V.sin(X), les valeurs de V.cos(X) et de V.sin(X) étant définies par des signaux élaborés sur la base du signal de commande et reçus par les multiplieurs sur leur deuxième entrée,
. un additionneur (40) présentant une première entrée reliée à la sortie du premier multiplieur, une deuxième entrée reliée à la sortie du deuxième multiplieur, et destiné à délivrer, sur une sortie reliée à la sortie du déphaseur programmable, un signal résultant de la somme des signaux reçus sur ses première et deuxième entrées,
**caractérisé en ce que**, le signal de commande est constitué d'un premier mot de commande (C[0:N-1]) définissant une valeur sensiblement égale à V.cos(X), et d'un deuxième mot de commande (S[0:N-1]) définissant une valeur sensiblement égale à V.sin(X), **en ce que** les multiplieurs sont des multiplieurs numériques, **en ce que** la deuxième entrée de chaque multiplieur est destinée à recevoir l'un des mots de commande, et **en ce que** chaque multiplieur est muni de moyens pour effectuer une multiplication du signal reçu sur sa première entrée par le signal reçu sur sa deuxième entrée.

2. Déphaseur programmable (PS) selon la revendication 1, **caractérisé en ce que**, le format des mots de commande étant de N bits, chaque multiplieur (20,30) comporte :
. un étage dit de commutation (31) composé de N-1 interrupteurs, chacun présentant une première et une deuxième bornes et une entrée, dite de commande, permettant de commander sa commutation, la première borne de chaque interrupteur étant reliée à la première entrée (IN) du multiplieur, les N-1 entrées de commande recevant N-1 bits provenant de la deuxième entrée du multiplieur,
. un additionneur (32) présentant une sortie et N-1 entrées, chacune reliée à la deuxième borne d'un des N-1 interrupteurs de l'étage de commutation, et
. un module dit d'inversion (33) présentant une première entrée reliée à la sortie de l'additionneur, une entrée de commande recevant celui des bits de la deuxième entrée du multiplieur qui ne commande aucun des interrupteurs de l'étage de commutation, appelé bit de signe, et une sortie (OUT) constituant la sortie du multiplieur, module d'inversion destiné à opérer l'inversion du signe d'un signal reçu sur sa première entrée si le bit de signe est à un état actif, et à fonctionner comme un suiveur sinon.

3. Déphaseur programmable (PS) selon la revendication 2, **caractérisé en ce qu'**un étage d'amplification (34) composé de N-1 amplificateurs est inséré au sein de chaque multiplieur (20,30), chaque amplificateur présentant une entrée reliée à la première entrée (IN) du multiplieur et une sortie, dont l'activation et la désactivation sont contrôlées au moyen de l'un des N-1 interrupteurs de l'étage de commutation (31), reliée à l'une des entrées de l'additionneur (32), le gain Gi du i^{ème} amplificateur (pour i=1 à N-1) étant égal à K fois le poids, au sein du mot de commande dont il provient, du bit commandant l'interrupteur qui contrôle l'activation et la désactivation de la sortie dudit i^{ème} amplificateur.

4. Convertisseur analogique/numérique, destiné à recevoir une tension d'entrée analogique (Va) à convertir en un signal de sortie numérique (Vout[]), comprenant :
. une échelle (100) de résistances placées en série entre deux bornes d'alimentation (Vbot,Vtop), résistances destinées à fournir à leurs noeuds intermédiaires une pluralité de tensions dites de référence,
. un étage (200) de comparateurs à deux entrées et une sortie, chacun destiné à recevoir sur une entrée la tension d'entrée analogique et sur l'autre entrée l'une des tensions de référence,
. un étage (300) de mémorisation composé de bascules mémoire, chacune reliée à la sortie d'un des comparateurs afin de mémoriser le résultat d'une comparaison, et destiné à recevoir sur une entrée d'horloge un signal dit d'échantillonnage,
. un encodeur binaire (400) connecté à l'étage de mémorisation pour en recevoir les informations mémorisées et fournissant le signal de sortie numérique du convertisseur,
**caractérisé en ce que** le convertisseur comporte en outre un déphaseur programmable (PS) conforme à l'une quelconque des revendications 1 à 3, destiné à recevoir sur sa première entrée un signal d'horloge (Ck) dont la fréquence est fixe, sur sa deuxième entrée un signal de commande numérique (CM[0:2N-1]), et à fournir en sortie le signal d'échantillonnage (Ss), lequel présente par rapport au signal d'horloge un déphasage dont la valeur est définie par le signal de commande.

## Claims

1. A programmable phase shifter (PS) having a first input intended to receive an input signal (Vin) to be phase-shifted, a second input intended to receive a digital control signal (CM[0:2N-1]), and an output intended to supply an output signal (Vout) which, with respect to the input signal, has a phase shift of which a value X is defined by the control signal, said programmable phase shifter comprising:
. a quadratic module (10) having an input which is connected to the first input of the programmable phase shifter, and an output intended to supply a signal which is in phase quadrature with the input signal,
. a first (20) and a second (30) multiplier each having a first and a second input and an output, the first input of the first multiplier being connected to the first input of the programmable phase shifter, the first input of the second multiplier being connected to the output of the quadratic module, the output of the first multiplier being intended to supply a signal resulting from the multiplication of the signal received at its first input by a value which is substantially equal to V.cos(X), in which V represents a DC voltage, the output of the second multiplier being intended to supply a signal resulting from the multiplication of the signal received at its first input by a value which is substantially equal to V.sin(X), the values V.cos(X) and V.sin(X) being defined by signals elaborated on the basis of the control signal and received by the multipliers at their second input,
. an adder (40) having a first input which is connected to the output of the first multiplier, a second input which is connected to the output of the second multiplier and intended to supply, at an output connected to the output of the programmable phase shifter, a signal resulting from the sum of the signals received at its first and second inputs,
**characterized in that** the control signal is constituted by a first control word (C[0:N-1]) defining a value which is substantially equal to V.cos(X) and a second control word (S[0:N-1]) defining a value which is substantially equal to V.sin(X), the multipliers are digital multipliers, the second input of each multiplier is intended to receive one of the control words, and each multiplier is provided with means for multiplying the signal received at its first input by the signal received at its second input.

2. A programmable phase shifter (PS) as claimed in claim 1, **characterized in that**, the format of the control words being N bits, each multiplier (20,30) comprises:
. a switching stage (31) composed of N-1 switches each having a first and a second terminal and a control input for controlling the switching operation, the first terminal of each switch being connected to the first input (IN) of the multiplier, the N-1 control inputs receiving N-1 bits from the second input of the multiplier,
. an adder (32) having an output and N-1 inputs, each being connected to the second terminal of one of the N-1 switches of the switching stage, and
. an inversion module (33) having a first input connected to the output of the adder, a control input receiving that bit, referred to as sign bit, from the second input of the multiplier which does not control any switch of the switching stage, and an output (OUT) constituting the output of the multiplier, said inversion module being intended to operate the inversion of the sign of a signal received at its first input if the sign bit is in an active state, and to function as a follower if the sign bit is in an inactive state.

3. A programmable phase shifter (PS) as claimed in claim 2, **characterized in that** an amplifier stage (34) composed of N-1 amplifiers is inserted within each multiplier (20,30), each amplifier having an input which is connected to the first input (IN) of the multiplier, and an output whose activation and deactivation are controlled by means of one of the N-1 switches of the switching stage (31), connected to one of the inputs of the adder (32), the gain Gi of the i^{th} amplifier (for i=1 to N-1) being equal to K times the weight, within the control word from which it originates, of the bit controlling the switch which controls the activation or deactivation of the output of said i^{th} amplifier.

4. An A/D converter intended to receive an analog input voltage (Va) to be converted into a digital output signal (Vout[]), said A/D converter comprising:
. a resistance ladder (100) arranged in series between two power supply terminals (Vbot,Vtop), which resistances are intended to supply a plurality of reference voltages at their junction points,
. a comparison stage (200) composed of comparators having two inputs and one output, each being intended to receive the analog input voltage at one input and one of the reference voltages at the other input,
. a memory stage (300) composed of flipflops, each being connected to the output of one of the comparators for storing the result of a comparison, and intended to receive a sampling signal at a clock input,
. a binary encoder (400) connected to the memory stage for receiving the stored data and for furnishing the digital output signal of the converter,
**characterized in that** the converter also comprises a programmable phase shifter (PS) as claimed in any one of claims 1 to 3, intended to receive a clock signal (Ck) having a fixed frequency at its first input, a digital control signal (CM[0:2N-1]) at its second input, and to supply the sampling signal (Ss) at its output, which sampling signal, with respect to the clock signal, has a phase shift whose value is defined by the control signal.

## Patentansprüche

1. Programmierbarer Phasenschieber (PS) mit einem ersten Eingang für den Erhalt eines Eingangssignals (Vin), in der Phase zu verschieben, einem zweiten Eingang für den Erhalt eines digitalen, sogenannten Steuersignals (CM[0:2N-1]) und einem Ausgang zur Abgabe eines Ausgangssignals (Vout) mit einer Phasenschiebung in bezug auf das Eingangssignal, deren Wert X von dem Steuersignal definiert wird, wobei der programmierbare Phasenschieber enthält:
. ein sogenanntes quadratisches Modul (10) mit einem Eingang, der mit dem ersten Eingang des programmierbaren Phasenschiebers und einem Ausgang zur Abgabe eines Signals in Phasenquadratur mit dem Eingangssignal verbunden ist,
. ein erstes (20) und ein zweites (30) Multiplizierwerk mit jeweils einem ersten und einem zweiten Eingang und einem Ausgang, wobei der erste Eingang des ersten Multiplizierwerks mit dem ersten Eingang des programmierbaren Phasenschiebers verbunden ist, der erste Eingang des zweiten Multiplizierwerks mit dem Ausgang des quadratischen Moduls verbunden ist, der Ausgang des ersten Multiplizierwerks dazu bestimmt ist, ein Signal abzugeben, das aus der Multiplikation des an seinem ersten Eingang erhaltenen Signals mit einem weitgehend bei V.cos(X) liegenden Wert erhalten wurde, wobei V eine Gleichspannung darstellt, der Ausgang des zweiten Multiplizierwerks dazu bestimmt ist, ein Signal abzugeben, das aus der Multiplikation des an seinem ersten Eingang erhaltenen Werts mit einem weitgehend bei V.sin(X) liegenden Wert erhalten wurde, wobei die Werte von V.cos(X) und von V.sin(X) von Signalen definiert werden, die auf Grundlage des Steuersignals erzeugt und von den Multiplizierwerken an ihrem zweiten Eingang erhalten werden,
. ein Addierwerk (40) mit einem ersten Eingang, mit dem Ausgang des ersten Multiplizierwerks verbunden, einem zweiten Eingang, mit dem Ausgang des zweiten Multiplizierwerks verbunden und dazu bestimmt, an einem Ausgang, mit dem Ausgang des programmierbaren Phasenschiebers verbunden, ein Signal abzugeben, das aus der Summe der an seinen ersten und zweiten Eingängen erhaltenen Signalen erhalten wird.
**dadurch gekennzeichnet, daß** das Steuersignal aus einem ersten Steuerwort (C[0:N-1]) gebildet wird, das einen Wert definiert, der weitgehend gleich mit V.cos(X) ist, und einem zweiten Steuerwort (S[0:N-1]), das einen Wert definiert, der weitgehend gleich mit V.sin(X) ist, daß die Multiplizierwerke digitale Multiplizierwerke sind, daß der zweite Eingang jedes Multiplizierwerks dazu bestimmt ist, eines der Steuerwörter zu erhalten und dadurch, daß jedes Multiplizierwerk Verfahren aufweist, um eine Multiplikation des an seinem ersten Eingang erhaltenen Signals mit dem an seinem zweiten Eingang erhaltenen vorzunehmen.

2. Programmierbarer Phasenschieber (PS) nach Anspruch 1, **dadurch gekennzeichnet, daß** das Format der Steuerwörter N Bits aufweist und jedes Multiplizierwerk (20,30) besteht aus:
. einer sogenannten Schaltstufe (31), bestehend aus N-1 Unterbrechern, von denen jeder eine erste und eine zweite Klemme und einen sogenannten Steuereingang aufweist, der es ermöglicht, ihre Schaltung zu steuern, wobei die erste Klemme jedes Unterbrechers mit dem ersten Eingang (IN) des Multiplizierwerks verbunden ist und die N-1 Steuereingänge N-1 Bits aus dem zweiten Eingang des Multiplizierwerks erhalten,
. einem Addierwerk (32) mit einem Ausgang und N-1 Eingängen, jeder mit der zweiten Klemme einer der N-1 Unterbrecher der Schaltstufe verbunden, und
. einem sogenannten Umkehrungsmodul (33) mit einem ersten Eingang, mit dem Ausgang des Addierwerks verbunden, einem Steuereingang, der dasjenige der Bits aus dem zweiten Eingang des Multiplizierwerks erhält, das keinen der Unterbrecher der Schaltstufe steuert, das sogenannte Zeichenbit, und einem Ausgang (OUT), der den Ausgang des Multiplizierwerks bildet, wobei das Umkehrungsmodul dazu bestimmt ist, die Umkehrung des Vorzeichens eines an seinem ersten Eingang erhaltenen Signals vorzunehmen, wenn das Zeichenbit in aktivem Zustand ist, und ansonsten wie ein Folger zu arbeiten.

3. Programmierbarer Phasenschieber (PS) nach Anspruch 2, **dadurch gekennzeichnet, daß** eine Verstärkerstufe (34), bestehend aus N-1 Verstärkern, im Rahmen jedes Multiplizierwerks (20,30) eingefügt ist, wobei jeder Verstärker einen Eingang aufweist, mit dem ersten Eingang (IN) des Multiplizierwerks verbunden, und einen Ausgang, dessen Aktivierung und Deaktivierung von einem der N-1 Unterbrecher der Schaltstufe (31) gesteuert wird, mit einem der Eingänge des Addierwerks (32) verbunden, wobei die Leistung Gi des i-ten Verstärkers (für i=1 bei N-1) gleich K mal das Gewicht ist, im Rahmen des Steuerworts, von der sie kommt, und des Bits, das den Unterbrecher schaltet, der die Aktivierung und Deaktivierung des Ausgangs des besagten i-ten Verstärkers steuert.

4. Analog-Digital-Umsetzer für den Erhalt einer analogen Eingangsspannung (Va) zur Umsetzung in ein digitales Ausgangssignal (Vout[]) mit:
. einer Widerstandsleiter (100), in Serie zwischen zwei Versorgungsklemmen (Vbot,Vtop) geschaltet, die Widerstände sind dazu bestimmt, eine Vielzahl sogenannter Bezugsspannungen an ihre Zwischenknoten zu liefern,
. einer Vergleicherstufe (200) mit zwei Eingängen und einem Ausgang, jeder dazu bestimmt, an einem Eingang die analoge Eingangsspannung und am anderen Eingang eine der Bezugsspannungen zu erhalten,
. einer Speicherstufe (300), bestehend aus Kippspeichern, die jeweils mit dem Ausgang einer der Vergleicher verbunden sind, um das Ergebnis eines Vergleichs zu speichern, und dazu bestimmt, um an einem Uhreingang ein sogenanntes Probenahmesignal zu erhalten,
. einem binären Kodierer (400), an die Speicherstufe angeschlossen, um gespeicherte Daten zu erhalten und das digitale Ausgangssignal des Umsetzers zu liefern,
**dadurch gekennzeichnet, daß** der Umsetzer zudem einen programmierbaren Phasenschieber (PS) gemäß einem beliebigen der vorangehenden Ansprüche 1 bis 3 aufweist, dazu bestimmt, an seinem ersten Eingang ein Ursignal (Ck), dessen Frequenz fest ist, an seinem zweiten Signal ein digitales Steuersignal (CM[0:2N-1]) zu erhalten und am Ausgang das Probenahmesignal (Ss) zu liefern, das in bezug auf das Uhrsignal eine Phasenschiebung aufweist, deren Wert von dem Steuersignal definiert wird.
